(19)

**Europäisches Patentamt**

**European Patent Office**

**Office européen des brevets**

(11)　**EP 1 333 111 A1**

(12)　**EUROPEAN PATENT APPLICATION**
published in accordance with Art. 158(3) EPC

(43) Date of publication:
　　**06.08.2003　Bulletin 2003/32**

(51) Int Cl.7: **C30B 19/12**, C01B 33/02,
　　H01L 21/208, H01L 31/04

(21) Application number: **01954473.3**

(22) Date of filing: **06.08.2001**

(86) International application number:
　　**PCT/JP01/06760**

(87) International publication number:
　　**WO 02/024982 (28.03.2002 Gazette 2002/12)**

(84) Designated Contracting States:
　　**AT BE CH CY DE DK ES FI FR GB GR IE IT LI LU
　　MC NL PT SE TR**

(30) Priority: **19.09.2000　JP 2000283036**

(71) Applicant: **Sharp Kabushiki Kaisha
　　Osaka 545-0013 (JP)**

(72) Inventors:
　　• **GOMA, Shuji
　　　Kitakatsuragi-gun, Nara 639-2122 (JP)**

　　• **TSUKUDA, Yoshihiro
　　　Fujiidera-shi, Osaka 583-0023 (JP)**
　　• **YANO, Kohzaburoh
　　　Nabari-shi, Mie 518-0740 (JP)**
　　• **TANIGUTI, Hiroshi
　　　Nara-shi, Nara 630-8244 (JP)**

(74) Representative: **Müller - Hoffmann & Partner
　　Patentanwälte,
　　Innere Wiener Strasse 17
　　81667 München (DE)**

(54)　**METHOD FOR PRODUCING CRYSTAL THIN PLATE AND SOLAR CELL COMPRISING CRYSTAL THIN PLATE**

(57)　Conventionally, it has been necessary to vary the cooling capacity to control the temperature of the growth face when a crystal thin film is grown, and it has been difficult to greatly vary the rate of flow of cooling water in the case of water cooling. Therefore the system needs to be of large scale and the production cost is high if the rate of flow of cooling gas is greatly varied in the case of gas cooling. According to the invention, the problems are thoroughly solved, and the control of the temperature of the surface from which a crystal thin plate is grown is easily performed, thus producing a crystal thin plate at low cost. Specifically, from that of the material of the other layer is brought into contact with a fusion of a substance from which a crystal containing at least either a material or a semiconductor material can be formed, and the temperature of the base is controlled so as to grow a crystal of a material from which the crystal can be formed on the base, thereby producing a crystal thin plate.

Fig. 1

## EP 1 333 111 A1

**Description**

Technical field

The present invention relates to a method for producing a crystal thin plate from a fusion containing a metallic material or a semiconductor material, and a solar cell comprising this crystal thin plate.

Prior art

Hitherto, as a method for producing a polycrystal silicon wafer used in a solar cell, there has been known a method of casting a polycrystal substance of silicon or the like, which is disclosed in, for example, Japanese Unexamined Patent Publication No. HEI 6(1994)-64913. That is, a high-purity silicon material to which a dopant such as phosphorus or boron is added is heated and fused in a crucible in an inert atmosphere. Next, this silicon fusion is poured into a mold and slowly cooled to obtain a polycrystal ingot. In the case that a polycrystal silicon wafer which can be used in a solar cell is formed from the thus-obtained polycrystal ingot, the ingot is sliced by use of a wire saw, an inner diameter blade method, or the like.

Another method as a method for producing a silicon crystal thin plate without using any slicing step is a method of producing a crystal thin plate, which is disclosed in Japanese Unexamined Patent Publication No. SHO 61(1986)-275119. This method is a method of immersing a part of a cylindrical rotary cooling body having therein a cooling means for water-cooling, air-cooling or some other cooling into a silicon fusion, and then pulling out a silicon coagulation nucleus generated on its cylindrical face, thereby yielding a silicon ribbon.

The structure of the rotary cooling body is a structure wherein the outside of a water-cooled metallic body made of copper or the like having a good heat conductivity is coated with a refractory material made of ceramic. According to this method, a silicon ribbon having an improved purity can be pulled out by purification effect, which is based on the discharge of an impurity element having an equilibrium distribution coefficient of less than 1 toward fused silicon.

Japanese Unexamined Patent Publication No. HEI 10(1998)-29895 also describes an apparatus for producing silicon ribbons. This silicon ribbon producing apparatus is mainly composed of a silicon heating/fusing section and a rotary cooling body made of a heat resistant material. The rotary cooling body, on which one end portion of a carbon net is beforehand wound, is brought into direct contact with a silicon fusion, thereby forming a silicon ribbon on the surface of the rotary cooling body. At the same time when the rotary cooling body is rotated, the wound carbon net is pulled out, whereby a silicon ribbon continuous to silicon fixed to the carbon net can be continuously taken out.

According to these methods, both of costs for the process and costs for the raw materials can be made lower than the conventional silicon wafer producing method, wherein the ingot is sliced with a wire saw or the like to yield a wafer. Since the rotary cooling body cools the silicon ribbon forcibly, pulls out the ribbon and supports the ribbon, the pulling-out speed can be highly improved. The pulling-out speed can be controlled dependently on the size and the rotation number of the rotary cooling body. In general, however, the ribbon can be pulled out at a speed of 10 cm/minute or more.

However, the above-mentioned conventional methods or apparatus for producing a silicon plate or a silicon thin plate have the following problems.

In the method of casting a polycrystal substance of silicon or the like, which is disclosed in the Japanese Unexamined Patent Publication No. HEI 6(1994)-64913, the step of slicing a polycrystal silicon ingot is necessary; therefore, a slice loss is generated by the thickness of the wire or the inner diameter blade. Thus, the yield is lowered as a whole. As a result, it is difficult to provide a low-cost wafer.

In the silicon ribbon producing method disclosed in the Unexamined Patent Publication No. SHO 61(1986)-275119, the rotary cooling body has therein a cooling mechanism for water-cooling or air-cooling; therefore, the rotary cooling body has a bilayer structure wherein the outside of a water-cooled metallic body made of copper or the like having a high heat conductivity is coated with a refractory material made of ceramic. The material which can be used for the metallic body is limited, dependently on cooling type, heat conductivity which satisfies cooling efficiency necessary for coagulating silicon, and some other factors. In particular, in the case that the water-cooling manner is used, water resistance and air-tightness are required since cooling water is conducted inside the cooling body. For this reason, the material which can be used is limited to highly strong metal which is not easily oxidized, as described above. The refractory material on which silicon is grown is also required to have a high strength at high temperature since the refractory material is directly immersed into fused silicon and a silicon ribbon is grown on the surface thereof. It is also necessary to prevent impurities from diffusing into the fused silicon and the silicon ribbon. Thus, the material which can be used is limited. As described above, the material of the rotary cooling body is limited; therefore, in order to perform temperature control of a growth face necessary for growing the thin plate, it is necessary to change the cooling capability.

For example, however, in the case that the cooling manner using water-cooling is used, it is difficult to change the flow rate of cooling water largely in order to prevent the boiling of the cooling water or member-damage based on high pressure. The temperature of the rotary cooling body becomes lower than a required temperature since the cooling efficiency of the cooling water is high. It is therefore difficult to control the temperature of the growth face.

In the case that air-cooling is used, the flow rate of cooling gas can be largely changed. Thus, the temperature can be relatively easily controlled. However, in order to satisfy cooling capability necessary for coagulating fused silicon, which has a melting point of 1400°C or more, a large flow rate of cooling gas is required. For this reason, costs for the cooling gas, and utilities associated with it, such pipes and supplying means, rise up. The scale for the utilities becomes large.

The control of the temperature of the rotary cooling body without changing the cooling capability can be attained by changing the thickness of the rotary cooling body. For example, however, in the case that the temperature is made lower, it is necessary to make the thickness considerably small. Thus, the strength of the rotary cooling body is damaged. Conversely, in the case that the temperature is made high, it is necessary to make the thickness considerably large. Thus, the scale of the apparatus becomes large.

In the silicon thin plate producing method disclosed in the Japanese Unexamined Patent Publication No. HEI 10(1998)-29895, the rotary cooling body has a bilayer structure wherein the surface of a rotary cooling body made of graphite is thinly coated with silicon nitride, which has high heat resistance and high strength, prevents impurities from diffusing into fused silicon and the silicon ribbon, and has bad wettability to silicon. Since the surface layer as one of the two layers is completely bonded to the rotary cooling body, it is sufficient that thickness thereof is very small. Therefore, the temperature of the rotary cooling body is substantially caused by heat conductivity of graphite. By changing the material of this rotary cooling body, the heat conductivity of the rotary cooling body can be changed. However, in the same manner as described above, the material which can be used is limited from the viewpoints of strength, prevention of impurity diffusion, and heat resistance. Thus, in order to perform the temperature control of the growth face of the thin plate to be necessary for growing the thin plate, it is necessary to change the cooling capability. However, in the same manner as described above, in the case of water-cooling, it is difficult to change cooling water. In the case of air-cooling, the scale of the apparatus becomes large and costs rise when cooling gas is largely changed.

Disclosure of the Invention

An object of the present invention is to dissolve such above situation basically, and perform easily the temperature control of a face where a crystal thin plate is grown so as to yield the crystal thin plate at low costs. The inventors examined the thickness of a base used for the production of a crystal thin plate, and/or the heat conductivity of the material constituting the base. As a result, it has been surprisingly found out that by adjusting them, a high-quality crystal thin plate can be provided at low costs. Thus, the present invention has been made.

Thus, according to the present invention, there is provided a method for producing a crystal thin plate, wherein a multilayer structure base comprising at least two layers, one of which is made of a material having a heat conductivity different from that of the material of the other layer is brought into contact with a fusion of a substance from which a crystal containing at least either a metallic material or a semiconductor material can be formed, and further the temperature of the base is controlled so as to grow a crystal of a substance from which the crystal can be formed on a surface of the base, thereby producing the crystal thin plate.

Furthermore, according to the present invention, there is provided a crystal thin plate produced by the above-mentioned crystal thin plate method.

According to the present invention, there is also provided a solar cell produced using the crystal thin plate.

Brief Description of the Drawings

Figure 1 is a view illustrating a silicon thin plate producing method according to First Example to Third Example in the present invention.

Figure 2 is a view illustrating a silicon thin plate producing method according to an effect example in the present invention.

Figure 3 is a view illustrating the silicon thin plate producing method according to an effect example in the present invention.

Figure 4 is a view illustrating a silicon thin plate producing method according to Fourth Example in the present invention.

Figure 5 is a view illustrating a silicon thin plate producing method according to Fifth Example in the present invention.

Figure 6 is a graph showing the temperature of a base surface when the thickness of an intermediate layer is changed.
Figure 7 is a graph showing the temperature of a base surface when the material of an intermediate layer is changed in the case that carbon is used in a surface layer and stainless steel is used in a rear face layer.
Figure 8 is a graph showing the temperature of a base surface when the material of an intermediate layer is changed in the case that carbon is used in a surface layer and copper is used in a rear face layer.

Embodiments of the Invention

In the present invention, a base is brought into contact with a fusion of a substance from which a crystal containing at least either a metallic material or a semiconductor material can be formed (the substance being referred to as the crystal forming substance hereinafter), to grow the crystal on a base surface, thereby obtaining a thin plate. At this time, by controlling the temperature of the base surface immediately before being brought into contact with the fusion of the crystal forming substance, it is possible to control the density of crystal nuclei generated on the base surface, the generation speed thereof, and the growing speed of the crystal grown from the crystal nuclei. As a result, the crystallinity (crystal grain size) and the thickness of the plate can be controlled.

As the methods of bringing the base into contact with the fusion, the following can be considered: a method of immersing the base surface (growth face) directly into the fusion of the crystal forming substance, a method of supplying the fusion of the crystal forming substance to the base surface, and other methods. As an example, the effect of the simplest method will be described, the method being a method of directing the base surface downwards along the gravity, moving the base in the direction along which the base surface is directed (downwards) so as to immerse the base surface into the fusion of the crystal forming substance positioned just under the base surface, and moving this upwards so as to take out the base from the fusion of the crystal forming substance.

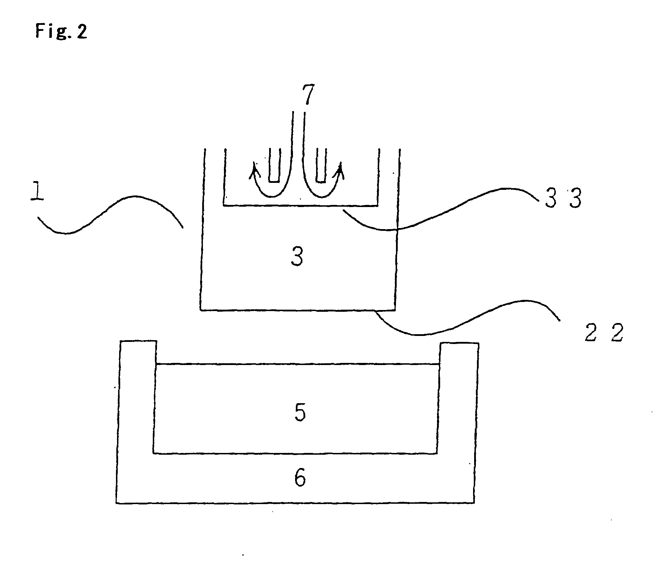

First, the effect in the case that the base is a monolayer structure will be described. As illustrated in Fig. 2, the structure of the base 1 is a rectangular parallelepiped 3' having, inside it, a path into which a cooling medium 7 passes. The cooling medium 7 takes heat of the rear face 33 of the base 1 so that the whole of the base is cooled. The material of the base is a single material. One of the methods for changing the temperature of the base surface 22 is a method of increasing and decreasing the heat-taking capability of the cooling medium 7. As described, however, in the case that the cooling manner based on water-cooling is used, it is difficult to change the flow rate of cooling water to a great degree. On the other hand, in the case that air-cooling is used, the flow rate of cooling gas can be largely changed. However, in order to cool, in particular, the base surface 22 to low temperature, a great amount of cooling gas is needed. Consequently, costs of the cooling gas, and utilities associated with it, such as pipes and supplying means, rise, and further the scale thereof becomes large.

In the method of changing thickness of the base (the distance from the base surface 22 to the rear face 33) to change the surface temperature largely, the temperature of the base surface 22 is substantially in proportion to the thickness. It is therefore necessary to change the thickness of the base largely. In many cases, however, the thickness of the base cannot be largely changed from the viewpoint of problems about the apparatus or strength. Thus, it is difficult to control the temperature by changing the thickness of the base. In the method of controlling the temperature of the base surface by changing the material of the base 1 and thus changing the heat conductivity, the heat conductivity of the base cannot be minutely changed. Additionally, restrictions that the following requirements must be satisfied are imposed on the material: both of the requirement that the base surface 22 immersed into the fusion 5 of the crystal forming substance has superior heat resistance, can resist used pressure, and does not contaminate the crystal thin plate; and the requirement based on a used cooling manner, in particular, the requirement that the base material can resist used water pressure and has water resistance in the case of a water-cooling manner. It is therefore difficult to control the temperature of the surface. In the figure, reference number 6 represents a crucible.

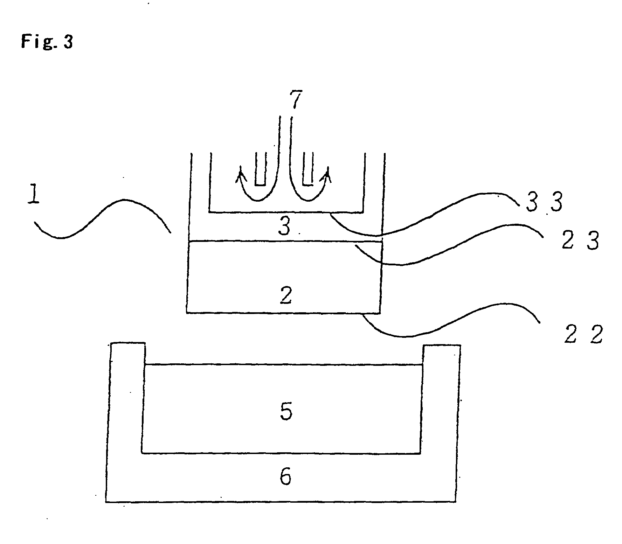

The following will describe the effect in the case that the base has a bilayer structure. As illustrated in Fig. 3, the structure of the base 1 is a structure wherein a surface layer 2 made of material constituting a base surface 22 (growth face) is arranged on a rectangular parallelepiped shaped rear face layer 3 having, inside it, a path into which a cooling medium 7 passes. As described above, the material of the rear face layer 3 is limited by the cooling manner or the like. The material of the surface layer 2 is also limited from the viewpoint of heat resistance and prevention of impurity contamination. In this case, however, the base 1 having two kinds of heat conductivities can be used, which is different from the case of the above-mentioned monolayer structure. Between the heat conductivities of the surface layer 2 and the rear face layer 3, a higher heat conductivity and a lower heat conductivity are represented by ka and kb, respectively. If no restriction is imposed on the thicknesses of the surface layer 2 and the rear face layer 3, the thickness of the surface layer 2 can be changed from 0 mm to the thickness of the base. If the thickness of the base is not changed at this time, the thickness of the rear face layer 3 changes from the thickness of the base to 0 mm. The apparent heat conductivity K of the whole of a base having a multilayer structure can be roughly calculated from the following equation when the heat conductivity of each of the layers i is represented by ki (change in the heat conductivity depending on temperature is neglected) and the thickness thereof is represented by Li:

$$1/K = \Sigma(Li/ki) \text{ wherein } \Sigma Li = \text{ the thickness of the base} \qquad \text{(numeral equation 1)}$$

As shown by this equation, the apparent heat conductivity of the bilayer base is within the range of kb to ka. As a practical matter, both of the thickness of the surface layer 2 and that of the rear face layer 3 are restricted (a minimum thickness and a maximum thickness are decided) on the basis of the strength and production process of the respective layers. As a result, the apparent heat conductivity of the base falls within a narrower range than the range of kb to ka. However, by changing the ratio between the thickness of the surface layer and that of the rear face layer in this way, the heat conductivity can be minutely and largely controlled without changing the thickness of the base. In this figure, reference number 23 represents the interface between the surface layer 2 and the rear face layer 3.

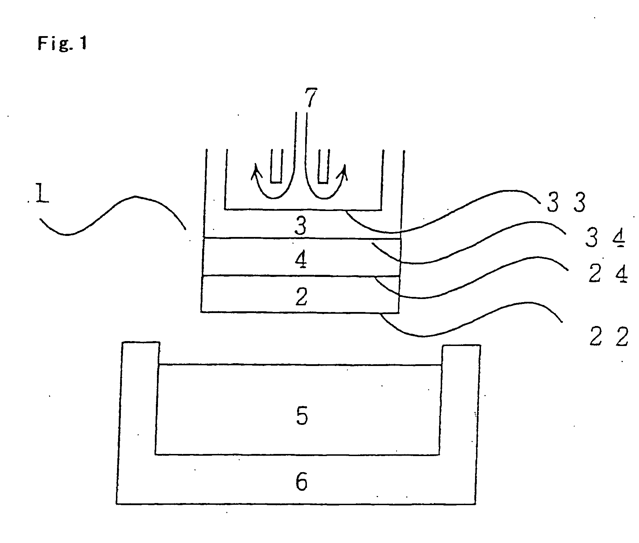

The following will describe the case that the base has a multilayer structure, that is, three-layer or more-layer structure. As illustrated in Fig. 1, the structure of the base 1 has a structure wherein an intermediate layer 4 is arranged between a rectangular parallelepiped shaped rear face layer 3 having, inside it, a path into which a cooling medium 7 passes, and a surface layer 2 made of material constituting the base surface 22 (growth face). As described above, the material of the rear face layer 3 is limited by the cooling manner or the like. The material of the surface layer 2 is also limited from the viewpoint of heat resistance or prevention of impurity contamination. The intermediate layer 4 is not limited by impurity contamination, water resistance or the like; therefore, the material thereof can be relatively freely changed to change the heat conductivity. In the figure, reference numbers 24 and 34 mean the interface between the surface layer 2 and the intermediate layer 4, and the interface between the intermediate layer 4 and the rear face layer 3, respectively.

In the case that the intermediate layer 4 is made to a multilayer structure having one or more layers, the whole thereof can be regarded as a single unified intermediate layer from the viewpoint of heat conductivity. For this reason, about the base having a multilayer structure, the effect of a three-layer structure having the surface layer 2, the intermediate layer 4 and the rear face layer 3 will be described. In the same manner as described above, between the heat conductivities of the surface layer 2 and the rear face layer 3, a higher heat conductivity and a lower heat conductivity are represented by ka and kb, respectively. Since the heat conductivity of the whole of the multilayer intermediate layer 4 can be roughly calculated from the numerical equation 1, the heat conductivity of the intermediate layer is represented by kc regardless of the layer number of the intermediate layer 4. In the case that the heat conductivity of at least one of the layers of the multilayer intermediate layer 4 is a value not less than the heat conductivities of both of the surface layer 2 and the rear face layer 3, the heat conductivity kc of the whole of the intermediate layer 4 can be set to ka or more by deciding the thickness of each of the layers appropriately, as can be calculated from the numerical equation 1. In the same manner, in the case that the heat conductivity of at least one of the layers of the multilayer intermediate layer 4 is a value not more than the heat conductivities of both of the surface layer 2 and the rear face layer 3, kc can be set to kb or less, as can be calculated from the numerical equation 1. Arrangement of a material having a high heat conductivity for the intermediate layer 3 containing the surface layer 2 produces an effect of decreasing in-plane temperature distribution of the base surface 22, which is easily caused in the case that the heat conductivity of the surface layer 2 is low.

In the case that the heat conductivity kc of the intermediate layer 4 is a value between the heat conductivity of the surface layer 2 and the heat conductivity of the rear face layer 3 (kb<kc<ka), the heat conductivity of the whole of the base can be delicately adjusted within the range of kb to ka only by changing the heat conductivity kc of the intermediate layer (that is, the material of the intermediate layer) within the above-mentioned range even if the thicknesses of the respective layers are not changed.

In the case that the heat conductivity kc of the intermediate layer 4 is a value not less than the heat conductivities of both the surface layer 2 and the rear face layer 3 (ka<kc), the heat conductivity of the whole of the base when the thicknesses of the respective layers are changed falls within the range of kb to kc. Thus, the heat conductivity within the range that can not be realized by any bilayer structure (kb or less and ka or more) can be realized by the use of the three-layer structure.

In the case that the heat conductivity kc of the intermediate layer 4 is a value not more than the heat conductivities of both the surface layer 2 and the rear face layer 3 (kb>kc), the heat conductivity of the whole of the base when the thicknesses of the respective layers are changed falls within the range of kc to ka. Thus, the heat conductivity within the range that can not be realized by any bilayer structure (kb or less and ka or more) can be realized by the use of the three-layer structure.

In the case that the fusion 5 of the crystal forming substance is brought into contact with the base surface 22 to grow a crystal thin plate, by controlling the temperature of the base surface 22 immediately before being brought into contact with the fusion of the crystal forming substance, it is possible to control the density of crystal nuclei generated on the base surface 22, the generation speed thereof, and the growing speed of the crystal grown from the crystal nuclei. In the case that the temperature of the base surface is set to far lower than the melting point of the crystal forming substance, the density of the crystal nuclei generated on the base surface, and the growing speed of the crystal increase. Therefore, the plate thickness of the crystal thin plate is larger as the temperature of the base surface is made lower. In the case that the temperature of the base surface is set to a high temperature close to the melting point of the crystal forming substance, the density of the crystal nuclei generated on the base surface, and the growing speed of the crystal decrease. Therefore, the plate thickness of the crystal thin plate is smaller as the temperature of the base surface is made higher. However, entire surface growth is not easily caused and chemical reaction between the base 1 and the fusion 5 is easily caused. Dependently on the material of the base, the wettability thereof to the fusion, and the kind of the crystal forming substance, temperature conditions are different but the grain size of the crystal grains can be controlled dependently on which of the speed at which the crystal nuclei are generated and the speed at which the crystal grows from the crystal nuclei is larger. In other words, the temperature of the base surface is controlled by making the base to a multilayer structure, changing the thicknesses of the respective layers, and changing the materials of the respective layers, whereby the crystallinity (the grain size of the crystal grains), and the plate thickness can be controlled. Therefore, a thin plate corresponding to a purpose can easily be obtained.

In particular, in the case that the above-mentioned method is used to take out a silicon thin plate, thereby producing a polycrystal solar cell, the photoelectric conversion efficiency of the solar cell is favorably higher as the plate thickness of the silicon thin plate is smaller and the crystal grain size is larger. In this case, a target silicon thin plate can be obtained by changing the materials of the rear face layer and the intermediate layer even if the thickness of the base or the material of the surface layer is not changed. Thus, the conversion efficiency of the solar cell can be improved.

Examples

The present invention will be described by way of examples, but the present invention is not limited to the examples. In the present examples, a fusion of a crystal forming substance is brought into contact with a base surface, whereby a monocrystal or polycrystal thin plate made of the crystal forming substance can be produced. The fusion of the crystal forming substance contains a semiconductor material such as silicon, germanium, gallium, arsenic, indium, phosphorus, boron, antimony, zinc or tin. A fusion containing a metallic material such as aluminum, nickel or iron can be used. Two or more kinds of these crystal forming substances may be mixed. In the present examples, silicon polycrystal thin plates were produced from silicon fusions.

(Example 1)

As illustrated in Fig. 1, Example 1 relates to a method of directing the base surface 22 downwards along the gravity, moving the base 1 in the direction along which the base surface is directed (downwards) so as to immerse the base surface 22 into the silicon fusion 5 positioned just under the base surface 22, and subsequently moving this upwards so as to take out the base surface 22, on which a crystal thin plate is formed, from the silicon fusion.

In the present example, for the control of the temperature of the base, there is used a water-cooling manner, in which cooling water (a cooling medium) is circulated to take heat of the rear face of the base, thereby performing cooling. However, gas can be used as the cooling medium.

The structure of the base 1 is made to have a three-layer structure, but a bilayer structure can be examined by integrating the intermediate layer 4 with the surface layer 2 or the rear face layer 3 and making the materials thereof equal.

In the present example, bases 1 under the following 4 conditions were prepared: (1) a three-layer base having an intermediate layer having a lower heat conductivity than those of both of a surface layer and a rear face layer, (2) a bilayer base wherein a layer having a smaller heat conductivity out of a surface layer and a rear face layer is integrated with an intermediate layer, (3) a bilayer base wherein a layer having a larger heat conductivity out of a surface layer and a rear face layer is integrated with an intermediate layer, and (4) a three-layer base having an intermediate layer having a higher heat conductivity than those of both of a surface layer and a rear face layer. Silicon thin plates (crystal thin plates) were then grown. About the heat conductivities of the entire bases 1, the (1) was lowest and the (4) was highest. The thicknesses of the surface layer 2, the intermediate layer 4 and the rear face layer 3 were 10 mm, 5 mm, and 10 mm, respectively.

About the (1) to the (4), the material of the surface layer 2 is desirably made to carbon, a ceramic (a carbide, an oxide, a nitride, or a boride such as silicon carbide, boron nitride, silicon nitride, silicon boride, quartz, or alumina), or a high melting point metal (metal comprising at least one selected from nickel, platinum, molybdenum and the like) as a material having superior heat resistance, resisting used pressure and not contaminating silicon thin plates. A surface layer in which the above is coated with a thin film of a high melting point material can also be used. Since the film thickness of the thin film is sufficiently smaller than the thickness of the surface layer, the heat conductivity thereof can be neglected. In the present example, carbon was used. The rear face layer 3 is desirably made of stainless steel, copper or some other material as a material having high strength and water resistance since cooling water is circulated under pressure in order to prevent the cooling water from evaporating and it is necessary to perform an operation that the base is immersed into the silicon fusion and taken out. In the present example, about all of the (1) to the (4) in Table 1, two cases were examined, one of which was a case in which stainless steel having a low heat conductivity but a high strength, was used in the rear face layer 3, and the other of which was a case in which copper having a high heat conductivity was used therein.

About the intermediate layer 4, various heat conductivities can be selected by changing the material thereof. In the present example, in the case of the (2), the intermediate layer was integrated with the rear face layer (stainless steel) when the surface layer was made of carbon and the intermediate was made of stainless steel, and the intermediate layer was integrated with the surface layer (carbon) when the rear face layer was made of copper and the intermediate layer was made of carbon. In the case of the (3), the intermediate layer was integrated with the surface layer (carbon) when the rear face layer was made of stainless steel and the intermediate was made of carbon, and the intermediate layer was integrated with the rear face layer (copper) when the surface layer was made of carbon and the intermediate layer was made of copper. In the case of the (1), as the material of the intermediate layer, quartz, which has a lower heat conductivity than those of carbon, stainless steel and copper, was used. In the case of the (4), as the material of the intermediate layer, aluminum, which has a higher heat conductivity than those of carbon and stainless steel, was used when the rear face layer was made of stainless steel and the surface layer was made of carbon, and silver, which has a higher heat conductivity than those of carbon and copper, was used when the rear face layer was made of copper and the surface layer was made of carbon. By setting the materials of the respective layers in this way, the heat conductivity of the whole of the base gets higher in the order from the (1) to the (4).

Table 1

|  | Base structure when the rear face layer was made of stainless steel | | | Base structure when the rear face layer was made of copper | | |
|---|---|---|---|---|---|---|
|  | Material of the surface layer | Material of the intermediate layer | Material of the rear face layer | Material of the surface layer | Material of the intermediate layer | Material of the rear face layer |
| (1) | Carbon | Quartz | Stainless steel | Carbon | Quartz | Copper |
| (2) | Carbon | Stainless steel | Stainless steel | Carbon | Carbon | Copper |
| (3) | Carbon | Carbon | Stainless steel | Carbon | Copper | Copper |
| (4) | Carbon | Aluminum | Stainless steel | Carbon | Silver | Copper |

Table 1 shows materials of the base surface layer, the intermediate layer and the rear face layer in the silicon thin plate producing method according to Example 1 in the present invention. Various combinations of the material of the surface layer, the material of the rear face layer and the material of the intermediate layer other than the above-mentioned combinations can be used.

As the method for connecting and integrating the respective layers of the multilayer structure base, a method of connecting them mechanically, such as fixation of them with screws, can be considered. In the case that the heat conductivity of the whole of the base is intended to be lowered, it is desired to reduce the contact area between the respective layers by subjecting the interface between the respective layers to unevenness working or grove working. In this case, gaps are formed on the interface between the respective layers so that heat conduction between the respective layers is reduced. As a result, the heat conductivity of the whole of the base can be lowered. In the case that the heat conductivity of the whole of the base is intended to be improved, it is desired to increase the contact area between the respective layers by making the interface between the respective layers as flat as possible. Furthermore, as the method for improving heat conduction between the respective layers, desired is a method of connecting the respective layers chemically, such as a method of stacking the bases into a multilayer structure and subsequently heating the structure. In the present example, connecting portions for integration were formed in the side face of the base, and the respective layers were connected by means of screws (not illustrated).

The shape of the base surface 22 can be made to a shape corresponding to a purpose, for example, a flat face, a curved face, or a face which is subjected to groove working and has a point-, line- or flat face-form apex. In the present example, the shape was made to a flat face.

A crucible 6 is arranged just under the base surface, and a heating heater for fusing silicon is arranged around the crucible 6. These are put in a rectangular parallelepiped shaped apparatus external walls and a heat insulating material (not illustrated). The inside of the apparatus is surrounded by the heat insulating material, and the apparatus is sealed in such a manner that the inside can be held in an argon atmosphere.

The crucible 6 was heated with the heater to fuse silicon in the crucible 6. Thereafter, the base 1 was held and stabilized just above the silicon fuse 5, and then a thermocouple (not illustrated) set on the base surface 22 was used to measure the temperature of the base surface.

Table 2

|  | Evaluation results of the silicon thin plate when stainless steel was used in the rear face layer | | | Evaluation results of the silicon thin plate when copper was used in the rear face layer | | |
|---|---|---|---|---|---|---|
|  | Temperature of the base surface (°C) | Plate thickness of the thin plate (µm) | Crystal grain size of the thin plate (mm) | Temperature of the base surface (°C) | Plate thickness of the thin plate (µm) | Crystal grain size of the thin plate (mm) |
| (1) | 1022 | 235 | 0.87 | 851 | 419 | 1.80 |
| (2) | 942 | 325 | 1.52 | 403 | 897 | 1.43 |
| (3) | 857 | 418 | 1.73 | 340 | 968 | 1.02 |
| (4) | 842 | 428 | 1.88 | 337 | 970 | 1.04 |

Table 2 shows the temperature of the base surface when the silicon thin plates were produced according to Example 1 in the present invention, the plate thickness of the produced silicon thin plates, and the crystal grain size. The temperature of the base surface is the result measured with the thermocouple. The differences between the surface temperatures in the (2) and the (3), in which stainless steel and copper were used in the rear face layer, were about 85°C and about 65°C, respectively. In the bilayer structure, the heat conductivity can also be changed. Moreover, the surface temperature can be controlled by changing the ratio between the thickness of the surface layer and that of the rear face layer. About the bilayer structures in the present example, the thicknesses of the surface layer and the rear face layer were changed by width of 10 mm. However, the surface temperature can be controlled into a wider range by changing the thicknesses more largely. Next, the differences between the surface temperatures in the (1) and the (4), in which stainless steel and copper were used in the rear face layer, were about 180°C and about 515°C, respectively. By making the three-layer structure, the heat conductivity can be more largely changed. Thus, the surface temperature can be controlled into a wider range. In the present example, the thicknesses of the surface layer, the intermediate layer, and the rear face layer were fixed. However, by changing these, the surface temperature can be controlled into a wider range than in the bilayer structure even if these are not changed.

Next, the base 1 to which no thermocouple was set was held just above the silicon fusion 5 and stabilized, and then the base was immersed into the silicon fusion by 20 mm. Immediately after the immersion, the base was pulled up to grow a silicon thin plate. The silicon thin plate was taken out after the temperature of the atmosphere lowered to room temperature. Thereafter, the plate thickness of the thin plate was measured. Subsequently, crystal grain boundaries of the thin plate were imaged by alkali etching. The average grain size of the crystal grains of the thin plate was measured.

As shown in Table 2, the plate thickness of the thin plate becomes thicker as the surface temperature becomes lower. Since the crystal grain size is decided by balance between the generation speed of crystal nuclei and the crystal growth speed, the optimal value of the surface temperature for giving a maximum crystal grain size exists. However, in the case that stainless steel is used in the rear face layer, a silicon thin plate having a large crystal grain size can be obtained by setting the heat conductivity of the intermediate layer to a larger value than the heat conductivities of the surface layer and the rear face layer. In the case that copper is used in the rear face layer, a silicon thin plate having a large crystal grain size can be obtained by setting the heat conductivity of the intermediate layer to a smaller value than the heat conductivities of the surface layer and the rear face layer. In the present example, a complicated base moving mechanism for continuous production and enlargement of the area of the thin plate are not considered. However, in the case that mass production is investigated, there is a strong possibility that a necessity that large strength is required dependently on the base is generated. Thus, a necessity that stainless steel having a small heat conductivity is used can be considered.

In the present example, the silicon thin plates were produced. However, in the case that a thin plate made of a crystal forming substance other than silicon is produced, the melting point of the fusion thereof, atmosphere temperature, surface temperature, and relationship between the surface temperature and the plate thickness and crystal grain size of the thin plate are different dependently on the material. For this reason, as in the present example, the control range of the surface temperature is made wider, whereby a plate thickness and a crystal grain size corresponding to a purpose can be obtained for thin plates made of various crystal forming substances.

(Example 2)

In the same manner as in Example 1, in Example 2 there will be described a method of directing the base surface 22 downwards along the gravity, moving the base 1 in the direction along which the base surface 22 is directed (downwards) so as to immerse the base surface 22 into the silicon fusion 5 positioned just under the base surface 22, and subsequently moving this upwards so as to take out the base surface 22, on which a crystal thin plate is formed, from the silicon fusion, as illustrated in Fig. 1.

In Example 1, there was described the case that the thicknesses of the surface layer, the intermediate layer and the rear face layer were 10 mm, 5 mm, and 10 mm, respectively. In the present example, there will be described the case that the thickness of the whole of the base was fixed to 25 mm and the thickness of the intermediate layer was changed. For controlling the temperature of the base, a water-cooling manner, in which cooling water (cooling medium) is circulated to take heat of the rear face of the base, thereby performing cooling, is used. However, gas can be used as the cooling medium.

In the same manner as in Example 1, in the present example, bases 1 under the following 4 conditions were prepared (see Table 1): (1) a three-layer base having an intermediate layer having a lower heat conductivity than those of both of a surface layer and a rear face layer, (2) a bilayer base wherein a layer having a smaller heat conductivity out of a surface layer and a rear face layer is integrated with an intermediate layer, (3) a bilayer base wherein a layer having a larger heat conductivity out of a surface layer and a rear face layer is integrated with an intermediate layer, and (4) a three-layer base having an intermediate layer having a higher heat conductivity than those of both of a surface layer and a rear face layer. Silicon thin plates were then grown. The thickness of the intermediate layer 4 was changed 2 mm by 2 mm within the range of 1 mm to 15 mm. Each of the thicknesses of the surface layer and the rear face layer was set to the half of the value obtained by subtracting the thickness of the intermediate layer from 25 mm. The thickness of the whole of the base (the sum of the thicknesses of the surface layer, the intermediate layer and the rear face layer) was fixed to 25 mm. In all of the (1) to the (4), carbon was used as the material of the surface layer 2. Stainless steel was used as the material of the rear face layer 3. The intermediate layer 4 was integrated with the rear face layer in the case of the (2), and was integrated with the surface layer in the case of the (3). As the material of the intermediate layer, quartz was used in the case of the (1), and aluminum was used in the case of the (4). The shape of the base surface was made to a flat face 22. In the present example, the respective layers were connected by means of screws.

A crucible 6 is arranged just under the base surface 22, and a heating heater for fusing silicon is arranged around the crucible 6. These are put in a rectangular parallelepiped shaped apparatus external walls and a heat insulating material (not illustrated). The inside of the apparatus is surrounded by the heat insulating material, and the apparatus is sealed in such a manner that the inside can be held in an argon atmosphere.

The crucible 6 was heated with the heater to fuse silicon in the crucible 6. Thereafter, the base 1 was stabilized while the base 1 was rotated. Thereafter, a thermocouple (not illustrated) set on the base surface 22 was used to measure the temperature of the base surface 22.

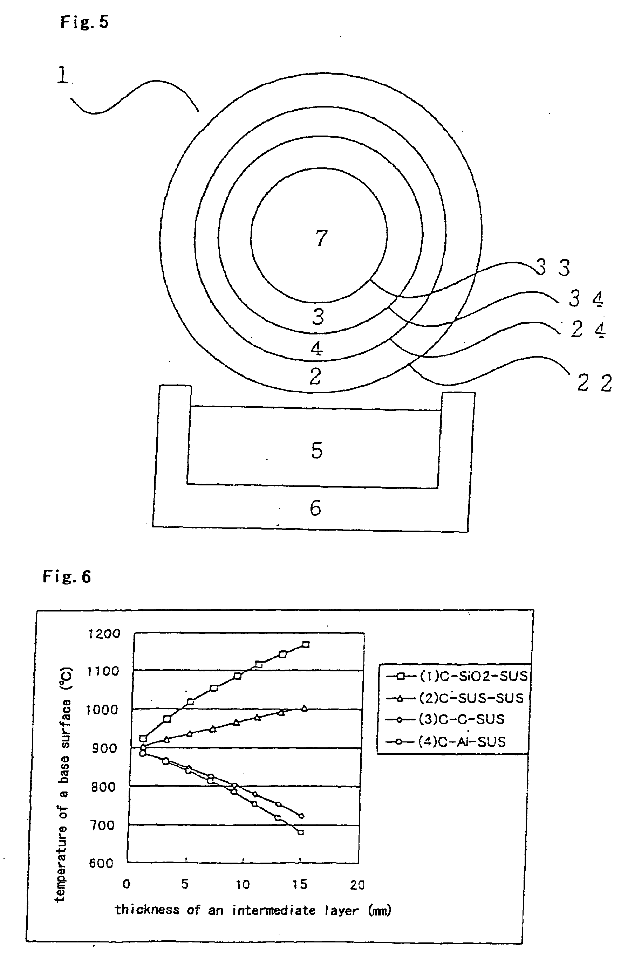

Figure 6 shows the temperature of the base surface when the intermediate layer thickness in the (1) to the (4) was changed. The cases of the (2) and the (3) are cases in which the thickness of the surface layer/the rear face layer of the bilayer structure base was changed. In the case that carbon was used in the intermediate layer as in the (2) (the case that the ratio of the surface layer was higher than that of the rear face layer in the bilayer structure), the surface temperature of the intermediate layer in thickness 15 mm was about 725°C. The surface temperature was about 885°C when the intermediate layer thickness was 1 mm. In the case that stainless steel was used in the intermediate layer as in the (3)(the case that the ratio of the surface layer was lower than that of the rear face layer in the bilayer structure), the surface temperature of the intermediate layer in thickness 1 mm was about 900°C. The surface temperature was about 1000°C when the intermediate layer thickness was 15 mm. That is, in the case that the minimum thicknesses of the surface layer and the rear face layer are set to 5 mm in the bilayer structure, the surface temperature can be adjusted within the range of about 725°C to about 1000°C by changing the thickness ratio between the surface layer and the rear face layer.

In the case that the material having a low heat conductivity is used in the intermediate layer as in the (1), the temperature of the base surface can be adjusted within the range of about 925°C to about 1165°C when the intermediate layer thickness is changed. In the case that the material having a high heat conductivity is used in the intermediate layer as in the (4), the temperature of the base surface can be adjusted within the range of about 675°C to about 885°C when the intermediate layer thickness is changed. That is, the temperature of the base surface can be adjusted within a wider range of about 675°C to about 1165°C than in the bilayer structure by forming the multilayer structure having three or more layers.

(Example 3)

In the same manner as in Example 1, in Example 3 there will be described a method of directing the base surface 22 downwards along the gravity, moving the base 1 in the direction along which the base surface 22 is directed (downwards) so as to immerse the base surface 22 into the silicon fusion 5 positioned just under the base surface 22, and subsequently moving this upwards so as to take out the base surface 22, on which a crystal thin plate is formed, from the silicon fusion, as illustrated in Fig. 1.

In Example 1, there was described the case that the heat conductivity of the intermediate layer 4 was not more than/not less than the heat conductivities of the surface layer 2 and the rear face layer 3. However, in the present example, there will be described the case that the heat conductivity of the intermediate layer 4 was not more than a larger one conductivity (ka) out of the heat conductivities of the surface layer 2 and the rear face layer 3, and was not less than a smaller one (kb) thereof, that is, the case of kb ≤ the heat conductivity of the intermediate layer ≤ ka. For controlling the temperature of the base, a water-cooling manner, in which cooling water (cooling medium) is circulated to take heat of the rear face of the base, thereby performing cooling, is used. However, gas can be used as the cooling medium.

The structure of the base 1 was made to a three-layer structure. In the present example, carbon was used as the material of the surface layer, and copper or stainless steel was used as the material of the rear face layer. The thicknesses of the surface layer 2, the intermediate layer 4 and the rear face layer 3 were set to 10 mm, 5 mm and 10 mm, respectively.

Since the material of the intermediate layer is not limited by any condition except that the material does not fuse or soften within used conditions, any material which is in a solid state within the used temperature range may be used. For example, the following may be used: a solid such as Ti, Zr, Sb, B, Pt, Fe, Ni, Co, Zn, Mo, Si, Mg, W, Be, Al or Au, or a compound, ceramic, metal or resin containing at least one or more selected from these elements.

In the present example, in the case that stainless steel was used in the rear face layer, Ti, Zr, Sb, B, Pt, Fe, Ni or Co, which has a heat conductivity between those of carbon and stainless steel, was used as the intermediate layer. In the case that copper was used in the rear face layer, Zn, Mo, Si, Mg, W, Be, Al or Au, which has a heat conductivity between those of carbon and copper, was used in the intermediate layer. In the present example, connecting portions for integration were formed in the side face of the base, and the respective layers were connected by means of screws. The shape of the base surface 22 was made to a flat face.

A crucible 6 is arranged just under the base surface, and a heating heater for fusing silicon is arranged around the crucible 6. These are put in a rectangular parallelepiped shaped apparatus external walls and a heat insulating material (not illustrated). The inside of the apparatus is surrounded by the heat insulating material, and the apparatus is sealed in such a manner that the inside can be held in an argon atmosphere.

The crucible 6 was heated with the heater to fuse silicon in the crucible 6. Thereafter, the base 1 was held just above the silicon fusion 5 and stabilized. Thereafter, a thermocouple (not illustrated) set on the base surface 22 was used to measure the temperature of the base surface.

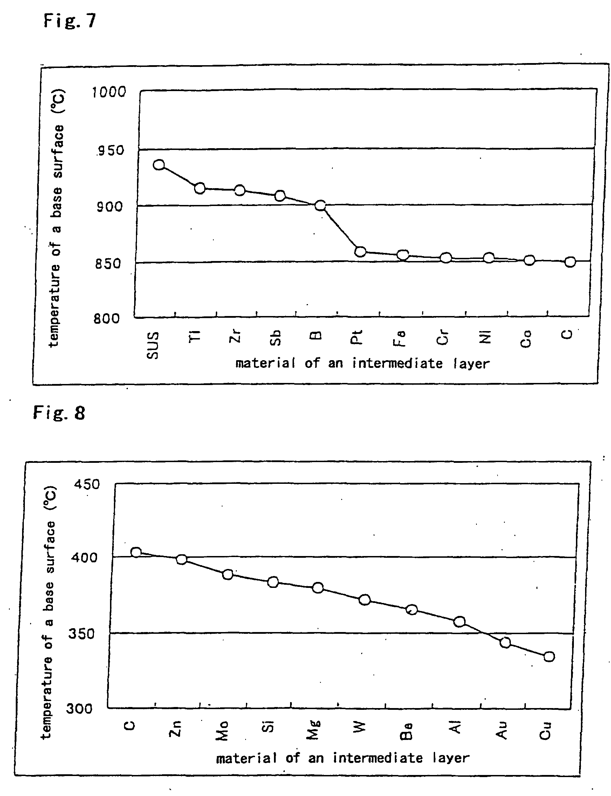

Figure 7 shows measured results of the temperature of the base surface with the thermocouple in the case that stainless steel was used in the rear face layer. For example, in the case that the thickness of the rear face layer was fixed to 10 mm, the case of the bilayer structure was equivalent to the case that the intermediate layer was made of carbon (C) and the surface temperature was about 850°C. In the case that the thickness of the surface layer was fixed to 10 mm, the case of the bilayer structure was equivalent to the case that the intermediate layer was made of stainless steel (SUS) and the surface temperature was about 940°C. When the temperature of the base surface is intended to be minutely set within the range of 850°C to 940°C without changing the thickness of the whole of the base, it is necessary to change both of the thicknesses of the surface layer and the rear face layer. In many cases, however, it is difficult to change the thickness of the surface layer for growing a crystal thin plate and the thickness of the rear face layer integrated with a moving section and a cooling medium path. Thus, it has been found out that when the material of the intermediate layer is changed without changing the thickness of the surface layer nor that of the rear face layer, the temperature of the base surface can be minutely adjusted within the range of 850°C to 940°C.

Figure 8 shows measured results of the temperature of the base surface with the thermocouple in the case that copper was used in the rear face layer. For example, in the case that the thickness of the rear face layer was fixed to 10 mm, the case of the bilayer structure was equivalent to the case that the intermediate layer was made of carbon (C) and the surface temperature was about 400°C. In the case that the surface layer was fixed into 10 mm, the case of the bilayer structure was equivalent to the case that the intermediate layer was made of copper (Cu) and the surface temperature was about 330°C. It has been found out that when only the material of the intermediate layer is changed without changing the thickness of the surface layer nor that of the rear face layer in the same manner as described above, the temperature of the base surface can be minutely adjusted within the range of 330°C to 400°C.

(Example 4)

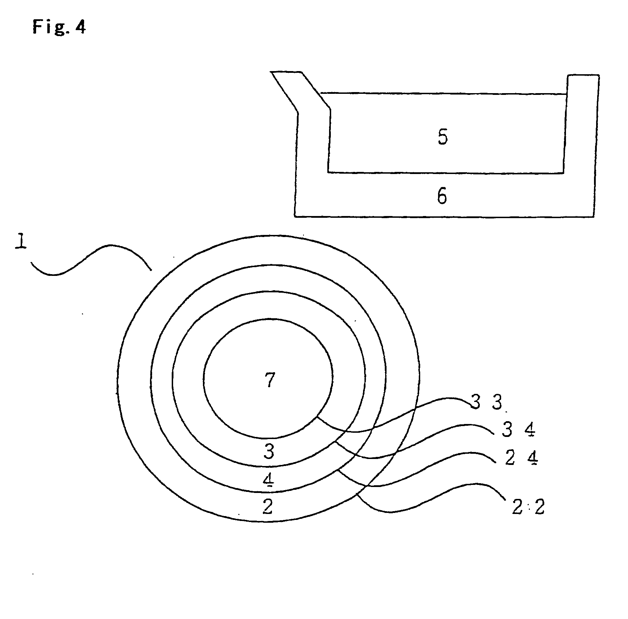

As illustrated in Fig. 4, the method of Example 4 is a method of rotating a hollow cylindrical three-layer base 1 in which a cooling medium 7 passes, and pouring a silicon fusion 5 directly onto the surface of the base, thereby growing a silicon thin plate on the base surface 22.

In the present example, a water-cooling manner was used in the same manner as in Example 1.

In the same manner as in Example 1, in the present example, bases 1 under the following 4 conditions were prepared (see Table 1): (1) a three-layer base having an intermediate layer having a lower heat conductivity than those of both of a surface layer and a rear face layer, (2) a bilayer base wherein a layer having a smaller heat conductivity out of a surface layer and a rear face layer is integrated with an intermediate layer, (3) a bilayer base wherein a layer having a larger heat conductivity out of a surface layer and a rear face layer is integrated with an intermediate layer, and (4) a three-layer base having an intermediate layer having a higher heat conductivity than those of both of a surface layer and a rear face layer. Silicon thin plates were then grown. The thicknesses of the surface layer 2, the intermediate layer 4 and the rear face layer 3 were 10 mm, 5 mm, and 10 mm, respectively. In all of the (1) to the (4), carbon was used as the material of the surface layer 2. Stainless steel and copper were used in the rear face layer 3, and the two cases were examined. In the case of the (2), the intermediate layer 4 was integrated with the rear face layer when the rear face layer was made of stainless steel, and was integrated with the surface layer when the rear face layer was made of copper. In the case of the (3), the intermediate layer 4 was integrated with the surface layer when the rear face layer was made of stainless steel, and was integrated with the rear face when the rear face layer was made of copper. As the material of the intermediate layer, quartz was used in the case of the (1). In the case of the (4), aluminum was used when the rear face layer was made of stainless steel, and silver was used when the rear face layer was made of copper. The shape of the base surface was made to a flat cylindrical side face 22.

A crucible 6 is arranged just above the base surface 22, and a heating heater for fusing silicon is arranged around the crucible 6. These are put in a rectangular parallelepiped shaped apparatus external walls and a heat insulating material (not illustrated). The inside of the apparatus is surrounded by the heat insulating material, and the apparatus is sealed in such a manner that the inside can be held in an argon atmosphere.

The crucible 6 was heated with the heater to fuse silicon in the crucible 6. Thereafter, the base 1 was stabilized while the base 1 was rotated. Thereafter, a thermocouple (not illustrated) set on the base surface 22 was used to measure the temperature of the base surface 22.

Table 3

| | Evaluation results of the silicon thin plate when stainless steel was used in the rear face layer | | | Evaluation results of the silicon thin plate when copper was used in the rear face layer | | |
|---|---|---|---|---|---|---|
| | Temperature of the base surface (°C) | Plate thickness of the thin plate (μm) | Crystal grain size of the thin plate (mm) | Temperature of the base surface (°C) | Plate thickness of the thin plate (μm) | Crystal grain size of the thin plate (mm) |
| (1) | 1023 | 238 | 0.98 | 847 | 420 | 1.86 |
| (2) | 944 | 326 | 1.47 | 405 | 898 | 1.44 |
| (3) | 850 | 416 | 1.76 | 339 | 968 | 1.14 |
| (4) | 847 | 428 | 1.88 | 342 | 968 | 1.06 |

Table 3 shows the temperature of the base surface, the plate thickness of the silicon thin plates, and the crystal grain size in the silicon thin plate producing method according to Example 4 in the present invention. The temperature of the base surface is the result measured with the thermocouple. The differences between the surface temperatures in the (2) and the (3), in which stainless steel and copper were used in the rear face layer, were about 95°C and about 65°C, respectively. On the other hand, the differences between the surface temperatures in the (1) and the (4), in which stainless steel and copper were used in the rear face layer, were about 175°C and about 505°C, respectively. Thus, by making the three-layer structure in the same manner as in Example 1, the heat conductivity can be more largely changed. Thus, the surface temperature can be controlled into a wider range.

Next, the base 1 to which no thermocouple was set was held just below the silicon fusion 5 and the crucible 6 and stabilized while the base 1 was rotated, and then the crucible 6 was inclined and moved to pour the silicon fusion 5 onto the base surface 22. After one rotation of the base, the pouring of the silicon fusion 5 was ended, thereby growing a silicon thin plate on the whole of the base surface. The silicon thin plate was taken out after the temperature of the atmosphere lowered to room temperature. Thereafter, the plate thickness of the thin plate and the average particle size were measured.

As shown in Table 3, the plate thickness of the thin plate becomes thicker as the surface temperature becomes lower. In the case that stainless steel is used in the rear face layer, a silicon thin plate having a large crystal grain size can be obtained by setting the heat conductivity of the intermediate layer to a larger value than the heat conductivities of the surface layer and the rear face layer in the same way as in Example 1. In the case that copper is used in the rear face layer, a silicon thin plate having a large crystal grain size can be obtained by setting the heat conductivity of the intermediate layer to a smaller value than the heat conductivities of the surface layer and the rear face layer.

(Example 5)

As illustrated in Fig. 5, the method of Example 5 is a method of rotating a hollow cylindrical three-layer base 1 in which a cooling medium 7 passes, and pushing up the crucible 6 filled with the silicon fusion 5 toward the base surface, thereby immersing the rotating base into the silicon fusion and growing a silicon thin plate on the base surface.

In the same manner as in Example 1, in the present example, bases 1 under the following 4 conditions were prepared (see Table 1): (1) a three-layer base having an intermediate layer having a lower heat conductivity than those of both of a surface layer and a rear face layer, (2) a bilayer base wherein a layer having a smaller heat conductivity out of a surface layer and a rear face layer is integrated with an intermediate layer, (3) a bilayer base wherein a layer having a larger heat conductivity out of a surface layer and a rear face layer is integrated with an intermediate layer, and (4) a three-layer base having an intermediate layer having a higher heat conductivity than those of both of a surface layer and a rear face layer. Silicon thin plates were then grown. The thicknesses of the surface layer, the intermediate layer and the rear face layer were 10 mm, 10 mm, and 5 mm, respectively. In all of the (1) to the (4), carbon was used as the material of the surface layer. Stainless steel and copper were used in the rear face layer, and the two cases were examined. In the case of the (2), the intermediate layer was integrated with the rear face layer when the rear face layer was made of stainless steel, and was integrated with the surface layer when the rear face layer was made of copper. In the case of the (3), the intermediate layer was integrated with the surface layer when the rear face layer was made of stainless steel, and was integrated with the rear face when the rear face layer was made of copper. As the material of the intermediate layer, quartz was used in the case of the (1). In the case of the (4), aluminum was used when the rear face layer was made of stainless steel, and silver was used when the rear face layer was made of copper. The shape of the base surface was made to a flat cylindrical side face 22.

A crucible 6 is arranged just under the base surface 22, and a heating heater for fusing silicon is arranged around the crucible 6. These are put in a rectangular parallelepiped shaped apparatus external walls and a heat insulating material (not illustrated). The inside of the apparatus is surrounded by the heat insulating material, and the apparatus is sealed in such a manner that the inside can be held in an argon atmosphere.

The crucible 6 was heated with the heater to fuse silicon in the crucible 6. Thereafter, the base 1 was stabilized while the base 1 was rotated. Thereafter, a thermocouple (not illustrated) set on the base surface 22 was used to measure the temperature of the base surface 22.

Table 4

| | Evaluation results of the silicon thin plate when stainless steel was used in the rear face layer | | | Evaluation results of the silicon thin plate when copper was used in the rear face layer | | |
|---|---|---|---|---|---|---|
| | Temperature of the base surface (°C) | Plate thickness of the thin plate (μm) | Crystal grain size of the thin plate (mm) | Temperature of the base surface (°C) | Plate thickness of the thin plate (μm) | Crystal grain size of the thin plate (mm) |
| (1) | 1024 | 237 | 0.97 | 852 | 420 | 1.92 |
| (2) | 939 | 322 | 1.51 | 413 | 898 | 1.43 |
| (3) | 854 | 418 | 1.82 | 347 | 969 | 1.04 |
| (4) | 845 | 428 | 1.95 | 339 | 967 | 0.99 |

Table 4 shows the temperature of the base surface, the plate thickness of the silicon thin plates, and the crystal grain size in the silicon thin plate producing method according to Example 5 in the present invention. The temperature of the base surface is the result measured with the thermocouple. The differences between the surface temperatures in the (2) and the (3), in which stainless steel and copper were used in the rear face layer, were about 85°C and about 65°C, respectively. The differences between the surface temperatures in the (1) and the (4), in which stainless steel and copper were used in the rear face layer, were about 180°C and about 515°C, respectively. Thus, by making the three-layer structure in the same manner as in Example 1, the heat conductivity can be more largely changed. Thus, the surface temperature can be controlled into a wider range.

Next, the base 1 to which no thermocouple was set was held just above the silicon fusion 5 and stabilized while the base was rotated. Thereafter, the crucible 6 was raised up to immerse the base 1 into the silicon fusion 5 by 20 mm. After one rotation of the base, the crucible 6 was pulled down to grow a silicon thin plate. The silicon thin plate was taken out after the temperature of the atmosphere lowered to room temperature. Thereafter, the plate thickness of the thin plate and the average particle size were measured.

As shown in Table 4, the plate thickness of the thin plate becomes thicker as the surface temperature becomes lower. In the case that stainless steel is used in the rear face layer, a silicon thin plate having a large crystal grain size can be obtained by setting the heat conductivity of the intermediate layer to a larger value than the heat conductivities of the surface layer and the rear face layer in the same way as in Example 1. In the case that copper is used in the rear face layer, a silicon thin plate having a large crystal grain size can be obtained by setting the heat conductivity of the intermediate layer to a smaller value than the heat conductivities of the surface layer and the rear face layer.

(Example 6)

The silicon thin plates produced in Examples 1, 4 and 5 were used to form solar cells. An example of the order of the steps for the formation is the following order: washing, texture etching, diffusion layer formation, oxide film removal, anti-reflection film formation, back etching, rear face electrode formation, and light-receiving face electrode formation. The steps are according to an ordinary method.

Table 5

| | | | Surface temperature (°C) | Crystal grain size of the thin plate (mm) | Property of the solar cell (%) |
|---|---|---|---|---|---|
| Example 1 | Stainless steel | (1) | 1022 | 0.87 | 8.1 |
| | | (2) | 942 | 1.52 | 11.5 |
| | | (3) | 857 | 1.73 | 14.1 |
| | | (4) | 842 | 1.88 | 14.7 |
| | Copper | (1) | 851 | 1.80 | 14.6 |
| | | (2) | 403 | 1.43 | 7.6 |
| | | (3) | 340 | 1.02 | 4.8 |
| | | (4) | 337 | 1.04 | 5.0 |
| Example 4 | Stainless steel | (1) | 1023 | 0.98 | 7.7 |
| | | (2) | 944 | 1.47 | 11.7 |
| | | (3) | 850 | 1.76 | 14.0 |
| | | (4) | 847 | 1.88 | 14.6 |
| | Copper | (1) | 847 | 1.86 | 14.2 |
| | | (2) | 405 | 1.44 | 7.7 |
| | | (3) | 339 | 1.14 | 4.6 |
| | | (4) | 342 | 1.06 | 4.5 |
| Example 5 | Stainless steel | (1) | 1024 | 0.97 | 7.9 |
| | | (2) | 939 | 1.51 | 11.6 |
| | | (3) | 854 | 1.82 | 13.9 |
| | | (4) | 845 | 1.95 | 14.2 |
| | Copper | (1) | 852 | 1.92 | 14.6 |
| | | (2) | 413 | 1.43 | 7.5 |
| | | (3) | 347 | 1.04 | 5.1 |
| | | (4) | 339 | 0.99 | 5.1 |

Table 5 shows results measured the property of the solar cells comprising the silicon thin plates produced by the silicon thin plate producing method with a solar simulator. The conversion efficiency of the solar cells in the case of using the bilayer structure as in the (2) and the (3) in Examples 1, 4 and 5 was 9.5% on average and was 14.1% at the maximum. In the case of using stainless steel in the rear face layer as in the (1), the conversion efficiency was improved to 14.5% on average and was 14.7% at the maximum by making the material of the intermediate layer to a material having a higher heat conductivity than the materials of the surface layer and the rear face layer. In the case of using copper in the rear face layer, the conversion efficiency was improved to 14.5% on average and was 14.6% at the maximum by making the material of the intermediate layer to a material having a lower heat conductivity than the materials of the surface layer and the rear face layer. By setting the heat conductivity of the intermediate layer to a higher value or a lower value than those of the materials of the surface layer and the rear face layer correspondingly to materials of the rear face layer and the surface layer as described above, the surface temperature is changed, whereby the crystal grain size can be controlled. For this reason, the temperature of the base surface can easily be set to a temperature condition which is best for solar cell property. Thus, the property of the solar cells can be largely improved.

As is evident from the above, according to the present invention by way of Examples 1 to 5, a base for growing a thin plate made of a crystal forming substance is made into a multilayer structure having three or more layers and the materials of the respective layers are selected, whereby the heat conductivity of the whole of the base can be changed without changing the size of the base nor the structure of the apparatus even if the materials of the rear face layer and the surface layer are limited by the crystal forming substance and the apparatus. Thus, the temperature of the base surface can be set to a temperature corresponding to a purpose. In this way, a crystal thin plate of the crystal forming substance having a crystal grain size and a plate thickness corresponding to the purpose can easily be yielded. According to the present invention by way of Example 6, the property of electronic parts can be improved by producing a crystal forming substance thin plate having a large crystal grain size suitable for the electronic parts such as solar cells by Examples 1 to 5.

## Claims

1.   A method for producing a crystal thin plate **characterized in that** a multilayer structure base comprising at least two layers, one of which is made of a material having a heat conductivity different from that of the material of the other layer, is brought into contact with a fusion of a substance from which a crystal containing at least either a metallic material or a semiconductor material can be formed, and further the temperature of the base is controlled so as to grow a crystal of the substance from which the crystal can be formed on a surface of the base, thereby producing the crystal thin plate.

2.   A method as set forth in claim 1, wherein the base has a multilayer structure of a surface layer and a rear face layer and materials of the surface layer and the rear face layer are a combination of carbon and stainless steel or a combination of carbon and copper.

3.   A method as set forth in claim 1 **characterized in that** the base has a multilayer structure of a surface layer, a rear face layer and at least one intermediate layer sandwiched therebetween, and the temperature of the base is controlled by the base having the intermediate layer including at least one layer made of a material whose heat conductivity is different from that of materials of the surface layer and the rear face layer.

4.   A method as set forth in claim 3 **characterized in that** the intermediate layer includes at least one layer made of a material having a heat conductivity lower than that of one of the surface layer and the rear face layer.

5.   A method as set forth in claim 3 **characterized in that** the intermediate layer includes at least one layer made of a material having a heat conductivity higher than that of one of the surface layer and the rear face layer.

6.   A method as set forth in claim 3 **characterized in that** the intermediate layer as a whole has a heat conductivity lower than that of one of the surface layer and the rear face layer.

7.   A method as set forth in claim 3 **characterized in that** the intermediate layer as a whole has a heat conductivity higher than that of one of the surface layer and the rear face layer.

8.   A method as set forth in claim 3, wherein materials of the surface layer, the intermediate layer and the rear face layer are selected from a combination of carbon, quartz and stainless steel, a combination of carbon, aluminum and stainless steel, a combination of carbon, quarts and copper, and a combination of carbon, silver and copper.

9.  A method as set forth in any one of claims 1 to 8, wherein the temperature of the base is controlled by varying the thickness of the layers of the materials.

10. A method as set forth in any one of claims 1 to 9, wherein the substance from which the crystal can be formed of is silicon.

11. A crystal thin plate produced by a method for producing a crystal thin plate as set forth in at least any one of claims 1 to 10.

12. A solar cell produced using a crystal thin plate according to claim 11.

Fig. 1

Fig. 2

Fig. 3

**Fig. 4**

1

2 · 2

2 4

3 4

3 3

5

6

7

3

4

2

Fig. 5

Fig. 6

temperature of a base surface (°C) vs thickness of an intermediate layer (mm)

- (1) C-SiO2-SUS
- (2) C-SUS-SUS
- (3) C-C-SUS
- (4) C-Al-SUS

Fig. 7

Fig. 8

| INTERNATIONAL SEARCH REPORT | International application No. |
|---|---|
| | PCT/JP01/06760 |

**A. CLASSIFICATION OF SUBJECT MATTER**
Int.Cl$^7$  C30B19/12, C01B33/02, H01L21/208, H01L31/04

According to International Patent Classification (IPC) or to both national classification and IPC

**B. FIELDS SEARCHED**

Minimum documentation searched (classification system followed by classification symbols)
Int.Cl$^7$  C30B1/00-35/00, C01B33/02, H01L21/208, H01L31/04

Documentation searched other than minimum documentation to the extent that such documents are included in the fields searched
| Jitsuyo Shinan Koho | 1926-1996 | Toroku Jitsuyo Shinan Koho | 1994-2001 |
| Kokai Jitsuyo Shinan Koho | 1971-2001 | Jitsuyo Shinan Toroku Koho | 1996-2001 |

Electronic data base consulted during the international search (name of data base and, where practicable, search terms used)
CAS ONLINE, JICST FILE on Science and Technology

**C. DOCUMENTS CONSIDERED TO BE RELEVANT**

| Category* | Citation of document, with indication, where appropriate, of the relevant passages | Relevant to claim No. |
|---|---|---|
| X | JP 61-275119 A (Kawasaki Steel Corporation), 05 December, 1986 (05.12.86), Claims; page 2, lower left column, line 7 to lower right column, line 8  (Family: none) | 1-2,9-12 |
| X | JP 62-79616 A (TDK Corporation), 13 April, 1987 (13.04.87), Claims; page 2, upper left column, line 14 to lower left column, line 17  (Family: none) | 1-2,9-12 |
| X | JP 9-110591 A (Shin-Etsu Chemical Co., Ltd.), 28 April, 1997 (28.04.97), Claims; Par. Nos. [0009], [0013] to [0015]  (Family: none) | 1-2,9-12 |
| A | JP 6-64913 A (Daido Hoxan Inc.), 08 March, 1994 (08.03.94)  (Family: none) | 1-12 |
| A | JP 10-29895 A (Sharp Corporation), 03 February, 1998 (03.02.98)  (Family: none) | 1-12 |

☐ Further documents are listed in the continuation of Box C.    ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 23 August, 2001 (23.08.01) | 04 September, 2001 (04.09.01) |

| Name and mailing address of the ISA/ | Authorized officer |
|---|---|
| Japanese Patent Office | |
| Facsimile No. | Telephone No. |

Form PCT/ISA/210 (second sheet) (July 1992)